# FASCICULE DE BREVET EUROPEEN

(11) **EP 3 220 726 B1**
(45) Date de publication et mention de la délivrance du brevet: **07.05.2025**
(21) Numéro de dépôt: 17160586.8
(22) Date de dépôt: 13.03.2017
(51) Int. Cl.: H05K 1/14, H05K 1/18, H05K 3/34

(54) **CARTE ÉLECTRONIQUE COMPRENANT UN CIRCUIT INTERCALAIRE À DEMI-TROUS MÉTALLISÉS**
ELEKTRONISCHE KARTE, DIE EINEN ZWISCHENSCHALTKREIS MIT METALLISIERTEN HALBLÖCHERN UMFASST
PRINTED CIRCUIT BOARD COMPRISING AN INTERPOSER WITH METAL-COATED HALF-HOLES

(30) Priorité: 15.03.2016 FR 1652177
(43) Date de publication de la demande: 20.09.2017
(73) Titulaire: ALSTOM Holdings, 93400 Saint-Ouen-sur-Seine (FR)
(72) Inventeur: REY, William, 69780 MION (FR)
(74) Mandataire: Plasseraud IP

(56) Documents cités:
- US-A- 4 412 642
- US-A1- 2002 093 803
- US-A1- 2008 278 920
- US-A1- 2014 124 256
- US-A1- 2015 279 770

## Description

La présente invention concerne une carte électronique selon le préambule de la revendication 1.

Une telle carte électronique résulte du remplacement d'un composant initial par un circuit imprimé intercalaire portant un composant de remplacement, lorsque le composant électronique initial présent dans un circuit imprimé devient obsolète, et qu'il n'existe pas de composant électronique de remplacement dont l'empreinte sur le circuit correspond parfaitement.

La conception et la fabrication d'un nouveau circuit imprimé adapté au composant électronique à jour, est une méthode coûteuse, surtout si elle doit être renouvelée régulièrement.

Ceci est particulièrement important dans les applications ferroviaires, où le remplacement d'un circuit imprimé nécessite des opérations de démontage complexes, et où le temps d'opération d'un dispositif électronique est long par rapport à la vitesse d'évolution des capacités des composants qui les composent.

Il est connu dans ce cas d'utiliser un circuit imprimé intercalaire recevant le composant électronique de remplacement. Ce circuit imprimé intercalaire est connecté par soudage au circuit électronique principal. Une telle opération de remplacement est bien moins coûteuse et plus simple à mettre en œuvre qu'un retraçage complet.

Des cartes électroniques comprenant des circuits intercalaires sont décrites dans les documents US 4412642 A, US 2008/278920 A1, US 2014/124256 A1 et US 2002/093803 A1, qui décrit le préambule de la revendication 1.

Cependant, les conditions d'opérations d'un circuit électrique dans des équipements ferroviaires sont souvent plus dures qu'en électronique classique. Les cartes électroniques doivent donc répondre à des normes de résistance aux contraintes environnementales et à la corrosion plus strictes.

Un but de l'invention est de fournir une carte électronique dont un composant électronique obsolète a été remplacé et présentant des caractéristiques de résistance aux contraintes environnementales et à la corrosion adaptées à l'utilisation en milieu ferroviaire.

A cet effet, l'invention concerne une carte électronique du type précité, selon la revendication 1.

La carte électronique selon l'invention peut comprendre l'une ou plusieurs des caractéristiques des revendications dépendantes, prise(s) isolément ou selon toute combinaison techniquement possible.

L'invention sera mieux comprise à la lecture de la description qui va suivre, donnée uniquement à titre d'exemple et faite en référence aux dessins annexés, parmi lesquels :
- la figure 1 est une vue en perspective d'un circuit imprimé intercalaire, portant un composant électronique ; et
- la figure 2 est une vue en coupe d'une partie d'une carte électronique selon l'invention.

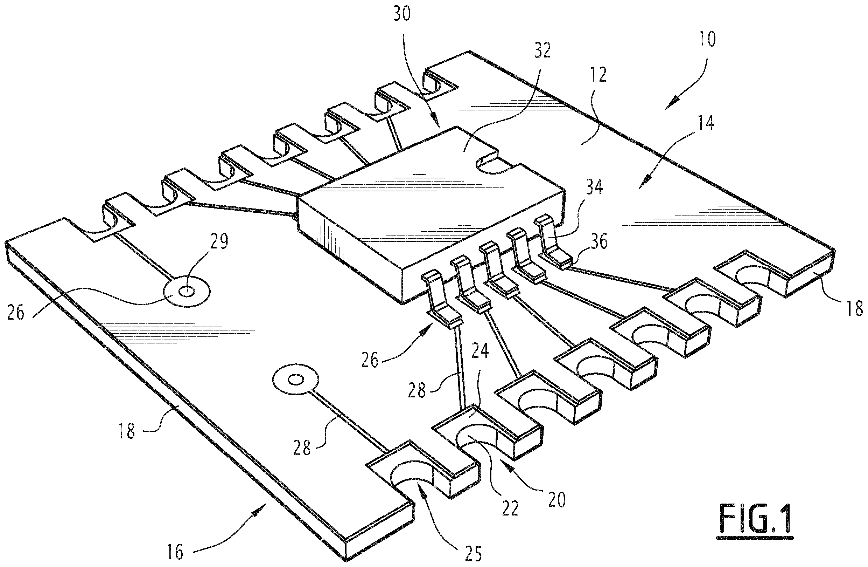

Un circuit imprimé intercalaire 10 est représenté sur la figure 1. Ce circuit imprimé comporte un substrat isolant 12, de la forme d'une plaque sensiblement rectangulaire présentant une face supérieure 14 et une face inférieure 16, ainsi que quatre bords latéraux 18. Le substrat a une longueur et une largeur comprises entre 2 mm et 40 mm selon les applications, pour une surface comprise entre 4 mm² et 1600 mm².

Pour assurer une rigidité suffisante du circuit imprimé intercalaire 10, le rapport de la longueur sur la largeur du substrat 12 est choisi inférieur à 6. De plus, le substrat 12 a une épaisseur de 0,8 mm, ce qui lui confère une rigidité suffisante pour une bonne durabilité. La rigidité n'est cependant pas trop grande, pour limiter les contraintes mécaniques locales dues aux variations de température.

Le substrat 12 est fabriqué à partir d'un matériau isolant, comme un composite de résine époxy et de fibres de verre tissées. Avantageusement, le matériau isolant est ignifugé par l'ajout d'un composé bromé dans la résine époxy. Par exemple, le matériau composite formant le substrat 12 est de classe FR-4 tel que décrit dans le standard LI 1-1998 (R2011) de la NEMA, « National Electrical Manufacturers Association ».

Le circuit imprimé intercalaire 10 comporte une pluralité de demi-trous métallisés 20 situés sur au moins deux bords latéraux 18. Dans l'exemple représenté sur la figure 1, le circuit imprimé intercalaire 10 comporte quatorze demi-trous métallisés 20 répartis également sur deux bords latéraux 18 opposés. En variante, le circuit imprimé intercalaire comporte par exemple vingt-huit demi-trous métallisés 20 répartis également sur les quatre bords latéraux 18. Les demi-trous 20 sont positionnés suivant un pas prédéterminé compris entre 0,4 mm et 1,27 mm.

Chaque demi-trou métallisé 20 est une encoche de section en demi-cercle, s'étendant dans le bord latéral 18 de la face supérieure 14 à la face inférieure 16. Chaque demi-trou métallisé présente une couche métallique 22, conductrice, par exemple en cuivre, qui s'étend sur l'intérieur de l'encoche à section en demi-cercle et se prolonge sur la face supérieure 14 du substrat 12 pour y former une languette 24 et sur la face inférieure 16 pour y former une languette 25.

Le circuit imprimé intercalaire 10 comporte également sur sa face supérieure 14 une pluralité de plages métalliques 26 conductrices, par exemple en cuivre.

Le circuit imprimé intercalaire 10 comporte en outre une pluralité de pistes 28, par exemple en cuivre, sur sa face supérieure 14. Chaque piste 28 relie électriquement soit au moins une plage métallique 26 à une languette 24, soit plusieurs plages métalliques 26 entre elles, et est apte à transmettre des signaux électriques.

Avantageusement, le circuit imprimé intercalaire 10 comporte également une pluralité de pistes 28, par exemple en cuivre, sur sa face inférieure 16, ainsi que des conduits 29 percés à travers le substrat 12, débouchant sur la face supérieure 14 et la face inférieure 16.

Chaque piste 28 de la face inférieure 16 relie électriquement au moins un conduit 29 à l'une des languettes 25, soit plusieurs conduits 29 entre eux, et est apte à transmettre des signaux électriques.

Les conduits 29 contiennent par exemple du cuivre et relient électriquement au moins l'une des pistes 28 de la face supérieure 14 à l'une ou plusieurs des pistes 28 de la face inférieure 16.

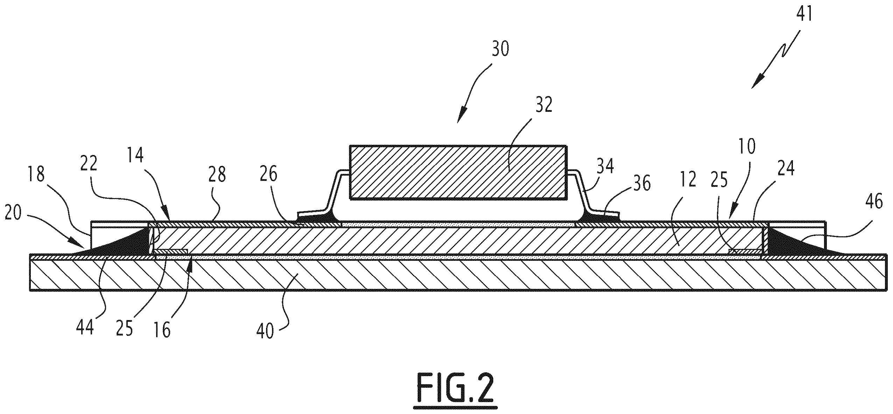

Comme représenté sur les figures 1 et 2, le circuit imprimé intercalaire 10 reçoit au moins un composant électronique 30 du côté de la face supérieure 14. Le composant électronique 30 est par exemple un circuit intégré comportant un boitier 32 et des pattes métalliques 34. Le boitier 32 contient des équipements électroniques aptes à effectuer des fonctions de traitement et de calcul à partir des signaux électroniques d'entrée reçus par le biais de certaines des pattes 34 du composant 30, et à émettre des signaux électriques de sortie par le biais d'autres pattes 34.

Chaque patte 34 du composant électronique 30 est fixée sur une des plages métalliques 26 par une soudure 36 située entre la patte 34 et la plage métallique 26. Dans l'exemple représenté figures 1 et 2, les soudures 36 sont sensiblement coniques, et sont réalisées par un procédé de brasage simple, ou par refusion.

Comme représenté sur la figure 2, le circuit imprimé intercalaire 10 est positionné sur un circuit imprimé principal 40 pour former une carte électronique 41 à plusieurs niveaux. Le circuit principal 40 présente des pistes 44, aptes à transmettre des signaux électriques.

Le circuit imprimé intercalaire 10 est connecté électriquement au circuit imprimé principal 40 par des soudures 46 situées au niveau des demi trous métallisés 20 et liant la couche métallique 22 de chaque demi-trou métallisé 20 à une piste 44. Les soudures 46 remplissent partiellement l'espace intérieur de chaque demi-trou métallisé 20, comme représenté sur la figure 2, et sont réalisées par un procédé de brasage simple ou par refusion.

Les soudures 46 assurent la connexion électrique entre les pistes du circuit imprimé principal 40 et du circuit imprimé intercalaire 10, ainsi que la liaison mécanique des circuits imprimés principal 40 et secondaire 10.

Les soudures 46 sont réalisées avec un premier matériau d'apport composé d'un alliage eutectique, c'est-à-dire à température de fusion constante, c'est-à-dire qui fond et se solidifie à température constante.

Le premier matériau d'apport avec lequel sont réalisées les soudures 46 est par exemple un alliage étain-plomb. Le premier matériau d'apport comprend une teneur massique en plomb comprise entre 33% et 40%, par exemple 37% et une teneur massique en étain comprise entre 60% et 67%, par exemple 63%.

En variante, le premier matériau d'apport avec lequel sont réalisées les soudures 46 est composé d'un alliage étain-argent ou étain-argent-cuivre ou étain-bismuth.

Le procédé utilisé pour réaliser les soudures 36 utilise un deuxième matériau d'apport. Le deuxième matériau d'apport comporte une teneur massique de plomb comprise entre 33% et 40%, par exemple 37% et une teneur massique en étain comprise entre 60% et 67%, par exemple 63%.

En variante, le deuxième matériau d'apport est un alliage étain-plomb-argent. La teneur massique d'étain est par exemple de 62%, tandis que la teneur massique de plomb est de 36% et que la teneur massique d'argent est de 2%.

La présence de plomb dans les premier et deuxième matériaux d'apport leur confère une température de fusion comprise entre 160°C et 200°C, notamment proche de 180°C, inférieure aux températures de fusion des matériaux utilisés dans les soudures de composants électroniques habituellement.

La présence de plomb dans les matériaux d'apport des soudures 36, 46 réduit également la susceptibilité des soudures 36, 46 à la corrosion et réduit le risque de casse prématurée de la carte électronique 41.

Des variantes de dimensions du substrat 12 et de pas entre les demi-trous 20 ont été testées et les résultats sont regroupés dans le tableau 1 suivant. Ces variantes correspondent à des composant remplacés de différentes tailles et présentant des nombres de pattes différents.

Les lignes du tableau 1 correspondent aux différentes dimensions du substrat 12 testées, pour lesquelles la surface est comprise entre 6 mm² et 1089 mm², et le rapport de la longueur sur la largeur est compris entre 1 et 4.

Les circuits intercalaires 10 ayant réussi des tests de résistance aux conditions environnementales, notamment aux brouillards salins, correspondent à une case indiquant un résultat validé. Les circuits intercalaires 10 ayant échoué à ces tests correspondent à une case indiquant un résultat rejeté. Les cases comprises verticalement entre deux cases validées sont validées a priori.

**Tableau 1**

| Pas | 0,4 mm | 0,5 mm | 0,65 mm | 0,8 mm | 1 mm | 1,27 mm |
|---|---|---|---|---|---|---|
| Substrat | | | | | | |
| 2x3 mm | | Validé | Validé | | | |
| 3x4 mm | | | | Validé | | |
| 5x5 mm | | | | | Validé | Validé |
| 7x8 mm | | Validé | Validé | | | |
| 7x10 mm | | Validé | | | | |
| 10x10 mm | | | | Validé | | |
| 9x12 mm | | | | | | Validé |
| 10x18 mm | | | Validé | | Validé | Validé |
| 13x13 mm | | | | | Validé | |
| 5x20 mm | | Rejeté | | | | |
| 15x15 mm | | Rejeté | | | | |
| 17x20 mm | | | Rejeté | Validé | | |
| 10x29 mm | | | | | | Validé |
| 20x27 mm | | | | Validé | Validé | |
| 33x33 mm | | | | | | Validé |

Le pas associé aux demi-trous 20 fixe le nombre de soudures 46 entre le circuit intercalaire 10 et le circuit principal 40. Ce nombre de soudures doit être suffisant pour avoir une bonne tenue de la carte électronique 41. Cependant, il ne doit pas être trop important pour limiter la rigidité de la carte électronique 41 et les contraintes mécaniques locales, notamment lors de variations de températures provoquant des dilatations du substrat 12.

Les valeurs de pas importantes sont donc plus adaptées aux grandes dimensions de substrat 12, et les valeurs de pas faibles aux petites dimensions. Ainsi, les valeurs proches de la première diagonale du tableau représentent des assemblages plus robustes pour la carte électronique 41.

## Revendications

1. Carte électronique (41) comportant :
- un circuit imprimé principal (40) comportant des pistes (44) ;
- un circuit imprimé intercalaire (10) positionné sur le circuit imprimé principal (40), comportant :
- un substrat (12) sensiblement rectangulaire, présentant une longueur et une largeur inférieure ou égale à la longueur, comportant une face supérieure (14), une face inférieure (16) et au moins un bord (18) ;
- au moins une piste métallique (28) située sur au moins l'une de la face supérieure (14) et de la face inférieure (16), apte à transmettre des signaux électriques ;
- une pluralité de demi-trous (20) reliant la face supérieure (14) et la face inférieure (16), situés au niveau du bord (18), présentant une couche métallique (22) recouvrant une surface interne de chaque demi-trou (20) ; et
- au moins un composant électronique (30) situé sur la face supérieure (14), relié électriquement aux pistes (28) du circuit imprimé intercalaire (10) par au moins une soudure (36) ;
le circuit imprimé intercalaire (10) étant connecté aux pistes (44) du circuit imprimé principal (40) par au moins une soudure (46) réalisée avec un premier matériau d'apport, située sur la couche métallique (22) de chaque demi-trou (20),
le substrat (12) ayant une surface comprise entre 4 mm² et 1600 mm², le rapport entre la longueur et la largeur du substrat (12) étant inférieur ou égal à 6, **caractérisée en ce que** chaque soudure (36) reliant le composant électronique (30) au circuit imprimé intermédiaire (10) est réalisée avec un deuxième matériau d'apport comportant une teneur massique en plomb supérieure à 33%, et
**en ce que** la combinaison de la largeur du substrat, la longueur du substrat et le pas séparant chaque demi-trou (20) du demi-trou (20) le plus proche est sélectionnée parmi les combinaisons suivantes : (2 mm, 3 mm, 0,5 mm), (2 mm, 3 mm, 0,65 mm), (3 mm, 4 mm, 0,5 mm), (3 mm, 4 mm, 0,65 mm), (3 mm, 4 mm, 0,8 mm), (5 mm, 5 mm, 0,5 mm), (5 mm, 5 mm, 0,65 mm), (5 mm, 5 mm, 0,8 mm), (5 mm, 5 mm, 1 mm), (5 mm, 5 mm, 1,27 mm), (7 mm, 8 mm, 0,5 mm), (7 mm, 8 mm, 0,65 mm), (7 mm, 8 mm, 0,8 mm), (7 mm, 10 mm, 0,5 mm), (7 mm, 10 mm, 0,65 mm), (7 mm, 10 mm, 0,8 mm), (7 mm, 10 mm, 1 mm), (10 mm, 10 mm, 0,65 mm), (10 mm, 10 mm, 0,8 mm), (10 mm, 10 mm, 1 mm), (9 mm, 12 mm, 0,65 mm), (9 mm, 12 mm, 0,8 mm), (9 mm, 12 mm, 1 mm), (10 mm, 18 mm, 0,65 mm), (10 mm, 18 mm, 0,8 mm), (10 mm, 18 mm, 1 mm), (13 mm, 13 mm, 0,8 mm), (13 mm, 13 mm, 1 mm), (15 mm, 15 mm, 0,8 mm), (15 mm, 15 mm, 1 mm), , (17 mm, 20 mm, 0,8 mm), (17 mm, 20 mm, 1 mm), (10 mm, 29 mm, 0,8 mm), (10 mm, 29 mm, 1 mm), (20 mm, 27 mm, 0,8 mm), (20 mm, 27 mm, 1 mm), (33 mm, 33 mm, 1,27 mm).

2. Carte électronique (41) selon la revendication 1, dans laquelle le substrat (12) est réalisé à partir d'un matériau composite comprenant une résine époxy et des fibres de verre.

3. Carte électronique (41) selon l'une quelconque des revendications précédentes, dans laquelle l'épaisseur du substrat (12) est sensiblement égale à 0,8 mm.

4. Carte électronique (41) selon l'une quelconque des revendications précédentes, dans laquelle les pistes (28) sont situées sur la face supérieure (14) du substrat (12) et comportent au moins une plage métallique (26) recevant une soudure (36) liant la plage métallique (26) à une patte (34) du composant électronique (30).

5. Carte électronique (41) selon l'une quelconque des revendications précédentes, dans laquelle le deuxième matériau d'apport est un alliage de plomb et d'étain comprenant une teneur massique en plomb comprise entre 33% et 40%.

6. Carte électronique (41) selon l'une quelconque des revendications précédentes, dans laquelle le deuxième matériau d'apport est composé d'un alliage de plomb et d'étain comprenant une teneur massique en étain comprise entre 60% et 67%.

7. Carte électronique (41) selon l'une quelconque des revendications précédentes, dans laquelle le premier matériau d'apport est composé d'un alliage eutectique choisi parmi un alliage étain-plomb, un alliage étain-argent-cuivre, un alliage étain-argent et un alliage étain-bismuth.

8. Carte électronique (41) selon l'une quelconque des revendications précédentes, dans laquelle le premier matériau d'apport est un alliage étain-plomb et comprend une teneur massique en plomb comprise entre 33% et 40%, de préférence égale 37% et une teneur massique en étain comprise entre 60% et 67%, de préférence égale à 63%.

9. Carte électronique (41) selon l'une quelconque des revendications précédentes, dans laquelle les premier et deuxième matériaux d'apport présentent une température de fusion comprise entre 160°C et 200°C, de préférence de l'ordre de 180°C.

## Patentansprüche

1. Elektronische Karte (41), umfassend:
- eine Hauptleiterplatte (40), umfassend Leiterbahnen (44);
- eine Zwischenleiterplatte (10), die auf der Hauptleiterplatte (40) positioniert ist, umfassend:
- ein im Wesentlichen rechteckiges Substrat (12), das eine Länge und eine Breite, die kleiner als oder gleich wie die Länge ist, aufweist, umfassend eine Oberseite (14), eine Unterseite (16) und mindestens einen Rand (18);
- mindestens eine metallische Leiterbahn (28), die sich auf mindestens einer von der Oberseite (14) und der Unterseite (16) befindet und geeignet ist, um elektrische Signale zu übertragen;
- eine Vielzahl von Halblöchern (20), die die Oberseite (14) und die Unterseite (16) verbinden, die sich an dem Rand (18) befinden und eine Metallschicht (22) aufweisen, die eine Innenfläche von jedem Halbloch (20) bedeckt; und
- mindestens eine elektronische Komponente (30), die sich auf der Oberseite (14) befindet und durch mindestens eine Lötstelle (36) elektrisch mit Leiterbahnen (28) der Zwischenleiterplatte (10) verbunden ist;
wobei die Zwischenleiterplatte (10) durch mindestens eine Lötstelle (46), die aus einem ersten Zusatzwerkstoff hergestellt wird und sich auf der Metallschicht (22) von jedem Halbloch (20) befindet, mit den Leiterbahnen (44) der Hauptleiterplatte (40) verbunden ist,
wobei das Substrat (12)
eine Fläche zwischen 4 mm² und 1600 mm² aufweist, wobei das Verhältnis zwischen der Länge und der Breite des Substrats (12) kleiner als oder gleich wie 6 ist, **dadurch gekennzeichnet,**
**dass** jede Lötstelle (36), die die elektronische Komponente (30) mit der Zwischenleiterplatte (10) verbindet, aus einem zweiten Zusatzwerkstoff mit einem Massengehalt an Blei von mehr als 33 % hergestellt wird, und
**dass** die Kombination aus der Breite des Substrats, der Länge des Substrats und dem Abstand, der jedes Halbloch (20) von dem nächstgelegenen Halbloch (20) trennt, ausgewählt ist aus den folgenden Kombinationen: (2 mm, 3 mm, 0,5 mm), (2 mm, 3 mm, 0,65 mm), (3 mm, 4 mm, 0,5 mm), (3 mm, 4 mm, 0,65 mm), (3 mm, 4 mm, 0,8 mm), (5 mm, 5 mm, 0,5 mm), (5 mm, 5 mm, 0,65 mm), (5 mm, 5 mm, 0,8 mm), (5 mm, 5 mm, 1 mm), (5 mm, 5 mm, 1,27 mm), (7 mm, 8 mm, 0,5 mm), (7 mm, 8 mm, 0,65 mm), (7 mm, 8 mm, 0,8 mm), (7 mm, 10 mm, 0,5 mm), (7 mm, 10 mm, 0,65 mm), (7 mm, 10 mm, 0,8 mm), (7 mm, 10 mm, 1 mm), (10 mm, 10 mm, 0,65 mm), (10 mm, 10 mm, 0,8 mm), (10 mm, 10 mm, 1 mm), (9 mm, 12 mm, 0,65 mm), (9 mm, 12 mm, 0,8 mm), (9 mm, 12 mm, 1 mm), (10 mm, 18 mm, 0,65 mm), (10 mm, 18 mm, 0,8 mm), (10 mm, 18 mm, 1 mm), (13 mm, 13 mm, 0,8 mm), (13 mm, 13 mm, 1 mm), (15 mm, 15 mm, 0,8 mm), (15 mm, 15 mm, 1 mm), , (17 mm, 20 mm, 0,8 mm), (17 mm, 20 mm, 1 mm), (10 mm, 29 mm, 0,8 mm), (10 mm, 29 mm, 1 mm), (20 mm, 27 mm, 0,8 mm), (20 mm, 27 mm, 1 mm), (33 mm, 33 mm, 1,27 mm).

2. Elektronische Karte (41) nach Anspruch 1, wobei das Substrat (12) aus einem Verbundmaterial hergestellt ist, umfassend ein Epoxidharz und Glasfasern.

3. Elektronische Karte (41) nach einem der vorherigen Ansprüche, wobei die Stärke des Substrats (12) im Wesentlichen gleich wie 0,8 mm ist.

4. Elektronische Karte (41) nach einem der vorherigen Ansprüche, wobei sich die Leiterbahnen (28) auf der Oberseite (14) des Substrats (12) befinden und mindestens eine Metallfläche (26) aufweisen, die eine Lötstelle (36) aufnimmt, die die Metallfläche (26) mit einer Lasche (34) der elektronischen Komponente (30) verbindet.

5. Elektronische Karte (41) nach einem der vorherigen Ansprüche, wobei der zweite Zusatzwerkstoff eine Blei-Zinn-Legierung ist, umfassend einen Massengehalt an Blei zwischen 33 % und 40 %.

6. Elektronische Karte (41) nach einem der vorherigen Ansprüche, wobei der zweite Zusatzwerkstoff eine Blei-Zinn-Legierung ist, umfassend einen Massengehalt an Zinn zwischen 60 % und 67 %.

7. Elektronische Karte (41) nach einem der vorherigen Ansprüche, wobei der erste Zusatzwerkstoff eine eutektische Legierung ist, die ausgewählt ist aus einer Zinn-Blei-Legierung, einer Zinn-Silber-Kupfer-Legierung, einer Zinn-Silber-Legierung und einer Zinn-Bismuth-Legierung.

8. Elektronische Karte (41) nach einem der vorherigen Ansprüche, wobei der erste Zusatzwerkstoff eine Zinn-Blei-Legierung ist und einen Massengehalt an Blei zwischen 33 % und 40 %, vorzugsweise 37 %, und einen Massengehalt an Zinn zwischen 60 % und 67 %, vorzugsweise 63 %, umfasst.

9. Elektronische Karte (41) nach einem der vorherigen Ansprüche, wobei das erste und das zweite Zusatzmaterial eine Schmelztemperatur zwischen 160 °C und 200 °C, vorzugsweise um 180 °C, aufweisen.

## Claims

1. An electronic board (41) including:
- a main printed circuit (40) including tracks (44);
- an interposed printed circuit (10) positioned on the main printed circuit (40), including:
- a substantially rectangular substrate (12), having a length and a width smaller than the length, including an upper face (14), a lower face (16) and at least one edge (18);
- at least one metal track (28) located on at least one of the upper face (14) and of the lower face (16), able to transmit electric signals;
- a plurality of half-holes (20) connecting the upper face (14) and the lower face (16), located at the edge (18), having a metal layer (22) covering an internal surface of each half-hole (20); and
- at least one electronic component (30) located on the upper face (14), electrically connected to the tracks (28) of the interposed printed circuit (10) through at least one solder (36) ;
the interposed printed circuit (10) being connected to the tracks (44) of the main printed circuit (40) through at least one solder (46) made with a first supply material, located on the metal layer (22) of each half-hole (20),
the substrate (12) having a surface area comprised between 4 mm² and 1,600 mm², the ratio between the length and the width of the substrate (12) being less than or equal to 6,
characterized and in that each solder (36) connecting the electronic component (30) to the interposed printed circuit (10) is made with a second supply material including a lead mass content of more than 33%, and
in that the combination of the width of the substrate, the length of the substrate and the pitch separating each half-hole (20) from the closest half-hole (20) is selected among the following combinations : (2 mm, 3 mm, 0.5 mm), (2 mm, 3 mm, 0.65 mm), (3 mm, 4 mm, 0.5 mm), (3 mm, 4 mm, 0.65 mm), (3 mm, 4 mm, 0.8 mm), (5 mm, 5 mm, 0.5 mm), (5 mm, 5 mm, 0.65 mm), (5 mm, 5 mm, 0.8 mm), (5 mm, 5 mm, 1 mm), (5 mm, 5 mm, 1.27 mm), (7 mm, 8 mm, 0.5 mm), (7 mm, 8 mm, 0.65 mm), (7 mm, 8 mm, 0.8 mm), (7 mm, 10 mm, 0.5 mm), (7 mm, 10 mm, 0.65 mm), (7 mm, 10 mm, 0.8 mm), (7 mm, 10 mm, 1 mm), (10 mm, 10 mm, 0.65 mm), (10 mm, 10 mm, 0.8 mm), (10 mm, 10 mm, 1 mm), (9 mm, 12 mm, 0.65 mm), (9 mm, 12 mm, 0.8 mm), (9 mm, 12 mm, 1 mm), (10 mm, 18 mm, 0.65 mm), (10 mm, 18 mm, 0.8 mm), (10 mm, 18 mm, 1 mm), (13 mm, 13 mm, 0.8 mm), (13 mm, 13 mm, 1 mm), (15 mm, 15 mm, 0.8 mm), (15 mm, 15 mm, 1 mm), (17 mm, 20 mm, 0.8 mm), (17 mm, 20 mm, 1 mm), (10 mm, 29 mm, 0.8 mm), (10 mm, 29 mm, 1 mm), (20 mm, 27 mm, 0.8 mm), (20 mm, 27 mm, 1 mm), (33 mm, 33 mm, 1.27 mm).

2. The electronic board (41) according to claim 1, wherein the substrate (12) is made from a composite material comprising an epoxy resin and glass fibers.

3. The electronic board (41) according to any of the preceding claims, wherein the thickness of the substrate (12) is substantially equal to 0.8 mm.

4. The electronic board (41) according to any of the preceding claims, wherein the tracks (28) are located on the upper face (14) of the substrate (12) and include at least one metal pad (26) receiving a solder (36) connecting the metal pad (26) to a pin (34) of the electronic component (30).

5. The electronic board (41) according to claim 5, wherein the second supply material is an alloy of lead and tin comprising a lead mass content comprised between 33% and 40%.

6. The electronic board (41) according to claim 6, wherein the second supply material consists of an alloy of lead and tin comprising a tin mass content comprised between 60% and 67%.

7. The electronic board (41) according to any of the preceding claims, wherein the first supply material consists of a eutectic alloy selected from among a tin-lead alloy, a tin-silver-copper alloy, a tin-silver alloy and a tin-bismuth alloy.

8. The electronic board (41) according to any of the preceding claims, wherein the first additional material is a tin-lead alloy and comprises a lead mass content comprised between 33% and 40%, preferably equal to 37% and a tin mass content comprised between 60% and 67%, preferably equal to 63%.

9. The electronic board (41) according to any of the preceding claims, wherein the first and second supply materials have a melting temperature comprised between 160°C and 200°C, preferably of the order of 180°C.
